## Europäisches Patentamt

## European Patent Office

## Office européen des brevets

(11) Numéro de publication: **0 216 673**
**B1**

(12) **FASCICULE DE BREVET EUROPEEN**

(45) Date de publication du fascicule du brevet:
**18.07.90**

(21) Numéro de dépôt: **86401863.5**

(22) Date de dépôt: **22.08.86**

(51) Int. Cl.⁵: **H01L 21/84,** H01L 21/86,
H01L 29/78

(54) **Procédé de fabrication d'un transistor de commande pour écran plat de visualisation, et élément de commande réalisé selon ce procédé.**

(30) Priorité: **27.08.85 FR 8512804**

(43) Date de publication de la demande:
**01.04.87 Bulletin 87/14**

(45) Mention de la délivrance du brevet:
**18.07.90 Bulletin 90/29**

(84) Etats contractants désignés:
**DE GB NL**

(56) Documents cités:
**EP-A- 0 103 523**
**US-A- 4 332 075**

(73) Titulaire: **THOMSON-CSF, 51, Esplanade du Général de Gaulle, F-92800 Puteaux(FR)**

(72) Inventeur: **Boulitrop, François, THOMSON-CSF SCPI 19, avenue de Messine, F-75008 Paris(FR)**
Inventeur: **Chartier, Eric, THOMSON-CSF SCPI 19, avenue de Messine, F-75008 Paris(FR)**
Inventeur: **Mourey, Bruno, THOMSON-CSF SCPI 19, avenue de Messine, F-75008 Paris(FR)**
Inventeur: **Le Berre, Serge, THOMSON-CSF SCPI 19, avenue de Messine, F-75008 Paris(FR)**

(74) Mandataire: **Lepercque, Jean et al, THOMSON-CSF SCPI, F-92045 PARIS LA DEFENSE CEDEX 67(FR)**

## Description

L'invention concerne un procédé de réalisation d'un transistor de commande pour écran plat de visualisation électrooptique et un transistor de commande réalisé selon ce procédé. Elle est applicable notamment à la réalisation d'écrans à cristal liquide de grande surface et plus particulièrement à l'intégration sous forme de couches minces des points de commande de l'écran.

Comme il est connu, ces écrans comportent généralement un grand nombre de points élémentaires ou éléments d'image de forme carrée ou rectangulaire. Ces éléments d'image doivent être adressés individuellement. La définition de l'écran est fonction du nombre de points susceptibles de recevoir une information. La commande de chaque point se fait par application d'un champ électrique à travers le cristal liquide. Pour la visualisation d'information vidéo, il a été proposé des affichages de type matriciel. Chaque élément d'image est alors défini par l'intersection de deux réseaux de conducteurs orthogonaux appelés lignes et colonnes.

L'adressage d'un élément d'image au moyen de tensions de commande appliquées à la ligne et à la colonne qui le concernent n'a pas besoin d'être maintenu si l'on adopte une technique de multiplexage temporel permettant par récurrence de rafraîchir l'état de l'écran. Cette technique se fonde sur un effet de persistance qui peut être physiologique ou disponible au sein de l'élément de l'écran.

Les points élémentaires commutation étant adressés séquentiellement ligne par ligne, le nombre de lignes pouvant être adressées est en général limité par les caractéristiques de l'effet électrooptique du cristal liquide utilisé. La possibilité d'adresser un grand nombre de lignes ( > 100) se fait alors au détriment des autres caractéristiques de l'écran (diminution du contraste et augmentation de la dépendance angulaire). Pour améliorer les performances de ces écrans, on peut mettre en série avec chaque point image (constituant une capacité) un transistor ou un élément non linéaire. L'ensemble se comporte alors comme un élément mémoire.

L'invention concerne un écran commandé par une matrice de transistors et son procédé de réalisation.

Actuellement, les exigences de la technique en matière d'écrans de visualisation portent en particulier, sur une meilleure définition de l'image. Dans le cas des écrans du type à affichage matriciel, on est alors amené à concevoir des dispositifs comportant un nombre élevé de lignes ou de colonnes d'adressage. Leurs nombres peut aller jusqu'à 512 ou même 1024. Ceci augmente d'autant le nombre de transistors de commande. Pour la fabrication en série, il est nécessaire notamment d'obtenir un rendement élevé, une bonne reproductibilité et une grande stabilité de ces composants. Il est en outre nécessaire d'adapter, et ce également avec une bonne reproductibilité, la capacité électrique du composant à celle de la cellule associée.

La réalisation d'une matrice de transistors en film mince (TFT) nécessite en général au moins quatre étapes de photolithographie avec des précisions de positionnement élevées. Ces transistors sont généralement réalisés dans la structure dite étagée inverse.

On connaît néanmoins des matrices de transistors réalisées en structure dite étagée directe telle que celle décrite dans l'article "Large LCD panel adressed by 320 × 320 TFT array" de J. Richard et al publié dans EURODISPLAY 84, Paris (1984). La technique décrite permet de se limiter à deux étapes de photolithographie mais présente des inconvénients tels que colonnes en ITO plus résistif que le métal et gravure délicate de cet ITO qui est dans un état totalement oxydé.

Certains de ces inconvénients ont été résolus en augmentant jusqu'à cinq le nombre d'étapes de photolithographie tel que cela a été décrit dans l'article "A 31, Inch a-Si TFT adressed colour LCD" de Toshio Yanagisawa et al publié dans EURODISPLAY 84, Paris 1984.

L'invention concerne un procédé qui, tout en conservant l'avantage de la réalisation des transistors au moyen de deux étapes de photolithographie ne nécessitant pas de positionnement critique, permet d'éliminer les inconvénients précédents et de supprimer des contraintes de fabrication, en n'ajoutant qu'une troisième étape de photolithographie pour la réalisation de l'ensemble de l'écran.

L'invention concerne donc un procédé de fabrication d'un transistor de commande pour écran plat de visualisation disposé sur une face plane d'un substrat, comportant les phases successives suivantes:

a) une première phase de dépôt, sur le substrat, d'un matériau conducteur oxydé;

b) une deuxième phase de découpe d'au moins une électrode de commande dans la couche de matériau conducteur;

c) une troisième phase de dépôt d'une première couche d'un matériau métallique;

d) une quatrième phase de dépôt d'une couche de semiconducteur amorphe dopé de type n;

e) une cinquième phase de découpe dans les couches de semiconducteur amorphe dopé de type n (4) et de matériau métallique déposées précédemment, d'au moins un élément de connexion dont une portion est en contact avec l'électrode et d'une colonne CL continue située à proximité de l'élément de connexion, déterminant la dimension du canal du transistor;

f) une sixième phase de dépôt d'une couche de matériau semiconducteur amorphe non dopé;

g) une septième phase de dépôt d'une couche de matériau isolant;

h) une huitième phase de dépôt d'une deuxième couche de matériau métallique;

i) une neuvième phase de découpe, dans les couches de matériau métallique, de matériau isolant et matériau semiconducteur amorphe non dopé, d'au moins une ligne chevauchant la colonne et l'élément de connexion.

L'invention concerne également un transistor de commande comportant au moins une électrode de commande en matériau conducteur oxydé déposée sur un substrat et comportant également: au moins un élément de connexion comprenant une première couche de matériau métallique déposée sur le substrat et en contact avec l'électrode de commande et une couche de semiconducteur amorphe dopé superposée à la couche précédente; une colonne située à proximité de l'élément de connexion et comprenant une couche continue de matériau métallique déposée sur le substrat et une couche de semiconducteur amorphe dopé déposée sur la couche précédente; une ligne en contact avec la colonne et l'élément de connexion et comprenant une couche de matériau semiconducteur amorphe non dopé chevauchant la ligne et l'élément de connexion une couche d'isolant et une couche de matériau métallique superposée à la couche précédente.

Les différents objets et caractéristiques de l'invention vont être détaillés en se reportant aux figures annexées qui représentent:

- les figures 1 à 7, les différentes phases du procédé selon l'invention;
- la figure 8, une vue en perspective du composant obtenu à l'issue de la phase représentée en figure 4;
- la figure 9, une vue en perspective du composant obtenu par le procédé de l'invention;
- la figure 10, une vue générale d'une matrice de commande d'écran plat obtenue par le procédé selon l'invention;
- les figures 11 et 12, une variante de réalisation selon l'invention;
- la figure 13, une autre variante de réalisation selon l'invention.

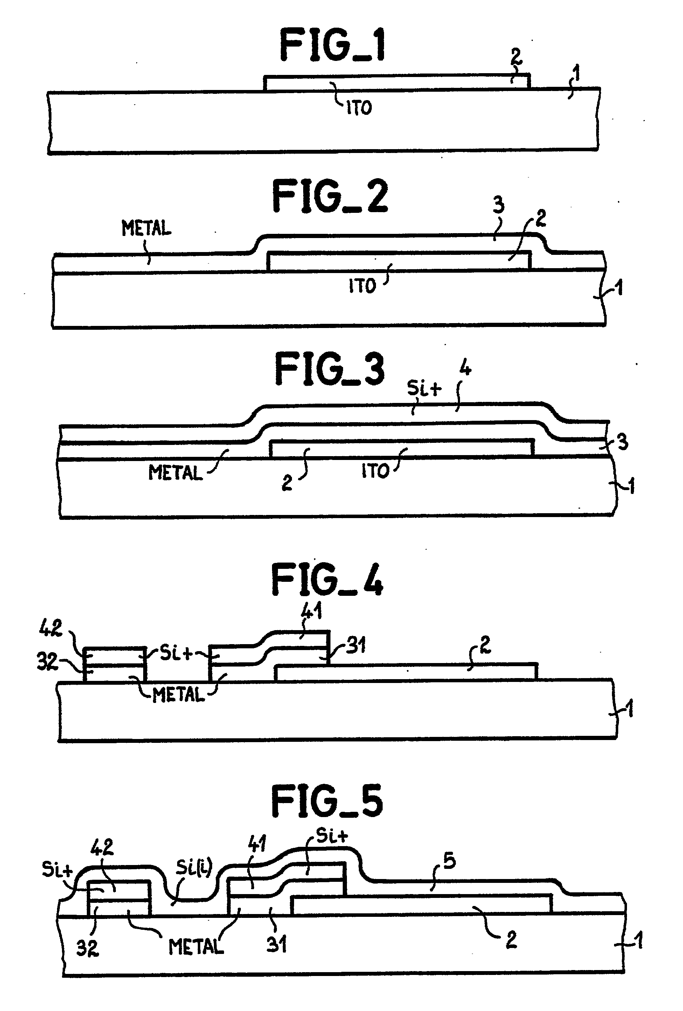

En se reportant aux figures 1 à 7, on va décrire les différentes phases du procédé de l'invention.

Au cours d'une première phase, on dépose sur un substrat 1, telle qu'une plaque de verre, une couche d'un matériau conducteur 2 qui peut être un matériau transparent dans le cas d'une utilisation dans un écran de visualisation fonctionnant en transparence. On pourra ainsi déposer une fine couche d'oxyde mixte d'étain et d'indium (ITO) ou un matériau équivalent ($In_2O_3$, $SnO_2$). Une telle couche aura une épaisseur de 50 à 150 nm de (500 à 1500 Angstroems), 125 nm (1250 Angstroems) par exemple. Un tel substrat en verre recouvert d'une couche d'ITO partiellement oxydée est disponible dans le commerce sous le nom, par exemple, de "Baltracon de Balzers". L'utilisation d'un tel substrat permet de se dispenser de cette première phase du procédé de l'invention.

Au cours d'une deuxième phase, la couche de matériau conducteur 2 est gravée à froid par un acide dilué de façon à réaliser sur la surface du substrat 1, des électrodes 2 telle que celle représentée en figure 1. L'avantage d'une gravure sur un matériau de type ITO partiellement oxydé réside dans la possibilité d'utiliser un acide dilué tandis qu'un ITO totalement oxydé nécessiterait une gravure à chaud au moyen d'un acide concentré.

Dans le cas d'une couche d'ITO partiellement oxydée, on prévoit après la phase de gravure, une phase de recuit sous atmosphère ambiante pour compléter l'oxydation de la couche.

Au cours d'une troisième phase, on dépose une couche d'un métal 3 tel que du chrome. Ce dépôt se fait par évaporation ou pulvérisation cathodique sous vide. L'épaisseur de la couche 3 doit être de quelques centaines, 60 nm (600 Angstroems) par exemple. On obtient ainsi une structure telle que représentée en figure 2.

Au cours d'une quatrième phase, on dépose une couche de matériau semiconducteur 4 fortement dopé de type n tel que du silicium amorphe. Ce dépôt se fait par une méthode connue de dépôt de silicium amorphe tel que décharge luminescente ou pulvérisation réactive. L'épaisseur de cette couche sera de 40 nm (400 Angstroems). On obtient ainsi une structure telle que représentée en figure 3.

Au cours d'une cinquième phase, on procède à la gravure des deux couches précédemment déposées (couche de silicium amorphe 4 et couche métallique 3) de façon à réaliser des éléments de connexion CX et des colonnes CL tel que représentés en figure 4. L'élément de connexion CX est constitué d'une couche 31 et d'une couche 41 gravées dans les couches 3 et 4 de la figure 3. De même, la colonne CL est constituée d'une couche 32 et d'une couche 42 gravées dans les couches 3 et 4.

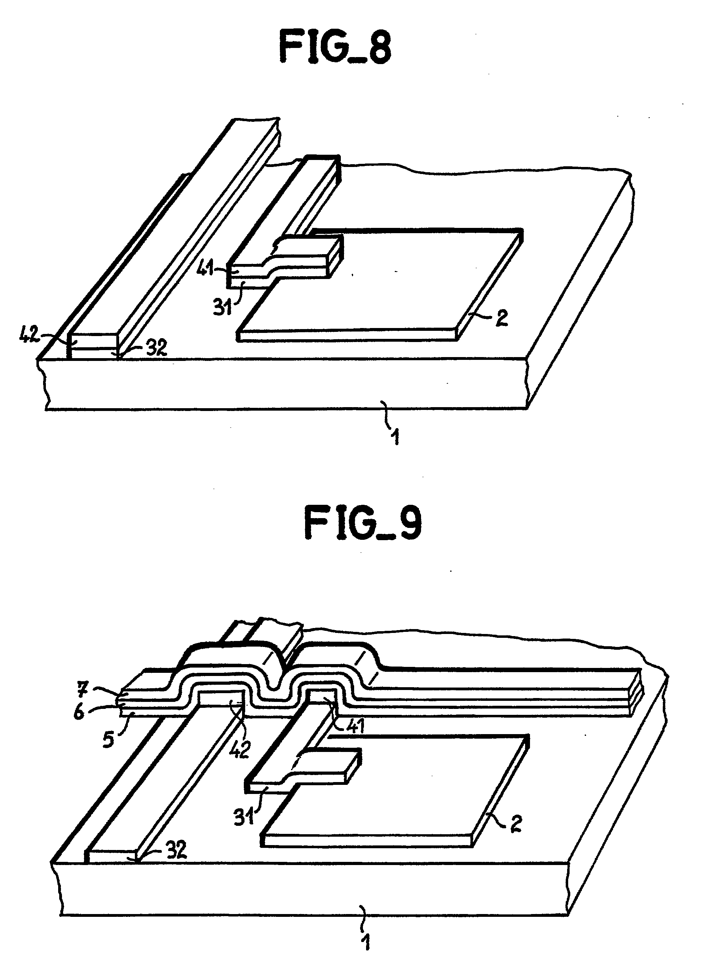

La figure 8 donne une vue en perspective de la structure ainsi obtenue. L'élément de connexion CX a la forme générale d'un L. L'une des branches du L est en contact avec l'électrode 2. L'autre branche du L est parallèle à la colonne CL.

Cette phase de gravure se fait par photolithographie et permet de définir à elle seule la géométrie du transistor (dimension du canal du transistor).

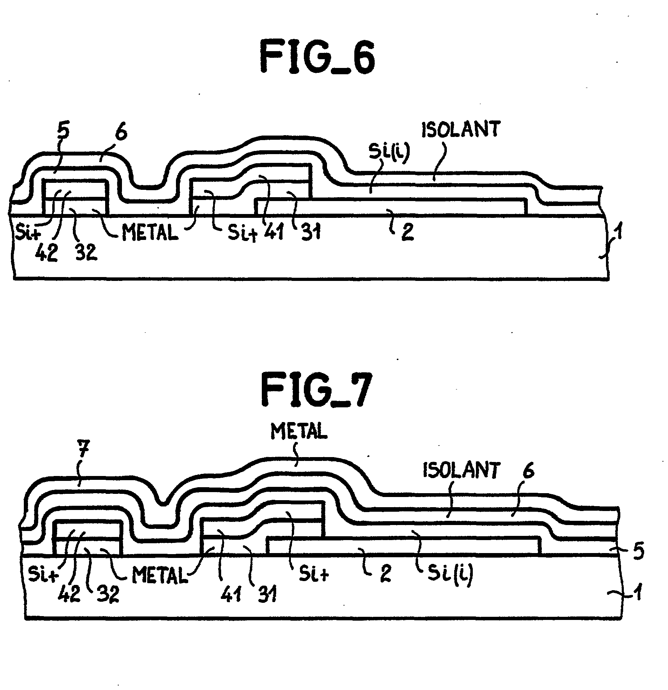

Au cours d'une sixième phase, on procède au dépôt d'une couche de semiconducteur 5, tel que du silicium, amorphe non dopé. Ce dépôt se fait à l'aide d'une méthode connue telle qu'une décharge luminescente ou pulvérisation réactive. L'épaisseur de la couche obtenue 300 nm (3000 Angstroems). L'ensemble obtenu est tel que représenté en figure 6.

Au cours d'une septième phase, on prévoit le dépôt d'une couche d'isolant 6 (isolant de grille) par une méthode analogue à celle de la sixième phase précédente. L'épaisseur de la couche d'isolant 6 est d'environ 150 nm (1500 Angstroems). L'isolant utilisé pourra par exemple, être en nitrite.

Au cours d'une huitième phase, on procède au dépôt d'une couche d'un matériau métallique 7, tel que de l'aluminium etc. Le procédé de dépôt d'une telle couche sera analogue à celui de la troisième phase de dépôt de la couche 3. L'épaisseur de la couche 7 sera d'environ 300 nm (3000 Angstroems).

Au cours d'une neuvième phase, on grave la couche métallique 7, la couche d'isolant 6, la couche de silicium 5, telle que représentée en figure 7, de façon à obtenir des lignes LG. Le silicium dopé des colonnes et éléments de connexion ne subsiste qu'aux intersections avec les lignes.

Sur la vue en perspective de la figure 9, on voit ainsi une ligne LG perpendiculaire à la colonne CL ainsi qu'une portion de l'élément de connexion CX. Cette opération de gravure se fait par photolithographie.

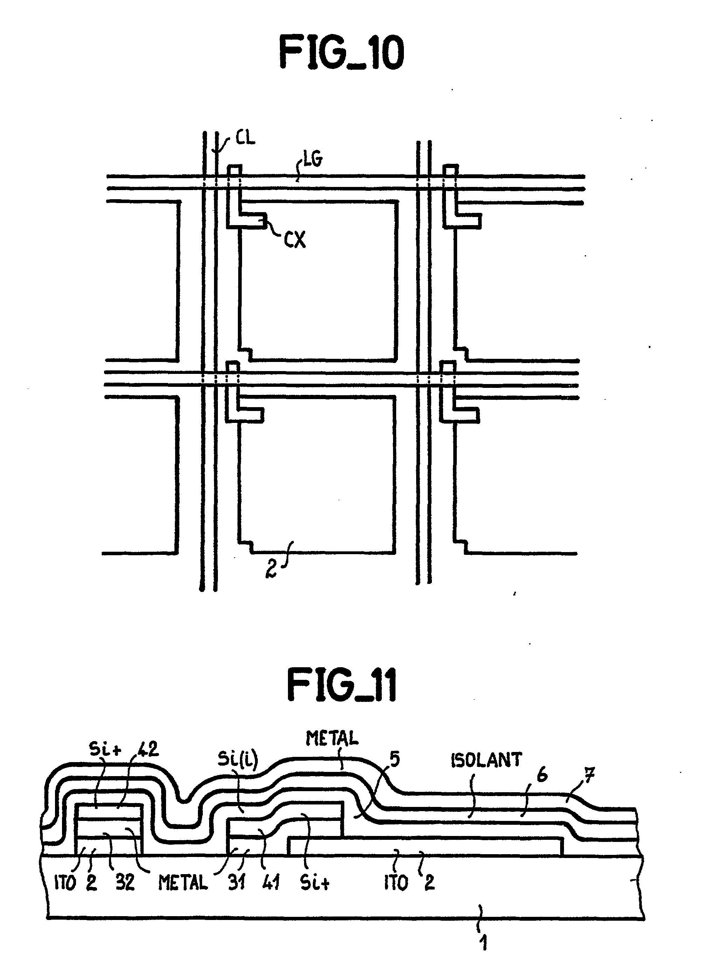

A ce stade, la commande intégrée est réalisée comme représenté en figure 10. Le substrat 1, portant des électrodes des lignes LG, des colonnes CL et des éléments de connexion CX à leurs points de croisement, peut être utilisé pour la fabrication d'écran à cristal liquide selon des technologies connues dans la technique. C'est ainsi que l'on sait qu'il sera souhaitable :
- de prévoir une couche d'ancrage (polyimide, SiO, etc...) ;
- des cales d'épaisseur pour prévoir un espace devant contenir le cristal liquide ;
- une contre-électrode transparente recouverte d'une couche d'ancrage.

Le cristal liquide sera alors contenu entre l'électrode 2 et une contre-électrode non représentée et pourra, par exemple, être observé en transmission, entre polariseurs croisés dans le cas d'une cellule de type nématique en hélice.

Selon l'invention, une colonne CL comportant une couche métallique 32 plus conductrice que l'ITO permet d'éviter les effets de lignes à retard dans les écrans de grandes dimensions.

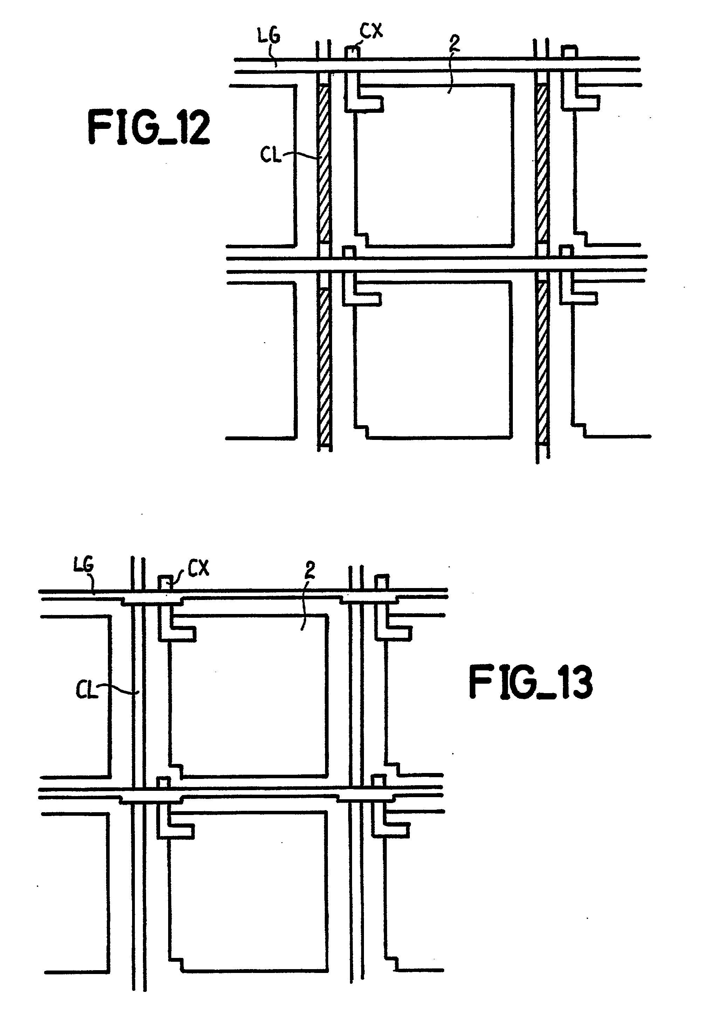

Pour éviter des coupures de colonnes et augmenter le rendement de fabrication utilisant le procédé de l'invention, on prévoit qu'au cours de la deuxième phase décrite précédemment, on grave également sur toute la longueur des futures colonnes, sauf à l'endroit de l'implantation des transistors de commande, des colonnes de matériau ITO. Comme représenté en figures 11 et 12, une colonne CL possédera une sous-couche d'ITO sur une longueur telle que celle représentée en hachures sur la figure 12.

Par ailleurs, comme cela est représenté en figure 13, chaque ligne LG peut posséder un élargissement au niveau de chaque point de croisement (transistor). Ceci permet de diminuer l'effet de transistor parasite pouvant exister entre le drain du transistor principal et la colonne suivante.

Il convient d'ajouter que les dépôts de couches silicium amorphe 5 et de matériau isolant 6, effectués au cours des sixième et septième phases précédemment décrites, peuvent être faits à travers un masque préservant la périphérie du substrat 1 de ces dépôts. Ainsi, les contacts périphériques de chaque ligne LG est réalisé directement sur le substrat par la couche métallique 7 déposée.

Enfin, il convient de signaler que le silicium amorphe dont le dépôt est prévu à la sixième phase peut être électriquement compensée ou même faiblement de type p afin de diminuer la photoconductivité et ainsi de limiter l'influence de la lumière sur les caractéristiques des transistors.

**Revendications**

1. Procédé de fabrication d'un transistor de commande pour écran plat de visualisation disposé sur un substrat (1), comportant les phases successives suivantes:
   a) une première phase de dépôt, sur le substrat (1), d'un matériau conducteur (2) oxydé;
   b) une deuxième phase de découpe d'au moins une électrode de commande (2) dans la couche de matériau conducteur;
   c) une troisième phase de dépôt d'une première couche d'un matériau métallique (3);
   d) une quatrième phase de dépôt d'une couche de semiconducteur amorphe dopé de type n (4);
   e) une cinquième phase de découpe dans les couches de semiconducteur amorphe dopé de type n (4) et de matériau métallique (3) déposées précédemment, d'au moins un élément de connexion (CX) dont une portion est en contact avec l'électrode (2) et d'une colonne (CL) continue située à proximité de l'élément de connexion (CX), déterminant la dimension du canal du transistor;
   f) une sixième phase de dépôt d'une couche de matériau semiconducteur amorphe non dopé (5);
   g) une septième phase de dépôt d'une couche de matériau isolant (6);
   h) une huitième phase de dépôt d'une deuxième couche de matériau métallique (7);
   i) une neuvième phase de découpe, dans les couches de matériau métallique (7), de matériau isolant (6) et de matériau semiconducteur amorphe non dopé (5), d'au moins une ligne (LG) chevauchant la colonne (CL) et l'élément de connexion (CX).

2. Procédé selon la revendication 1, caractérisé en ce que le matériau (2) déposé sur le substrat (1) au cours de la première phase est un oxyde métallique partiellement oxydée, que la découpe de la deuxième phase se fait par attaque à l'aide d'un acide dilué et que la deuxième phase est complétée par une phase de recuit à l'air ambiant pour oxyder complètement la couche d'oxyde métallique.

3. Procédé selon la revendication 1, caractérisé en ce que la deuxième phase de découpe d'au moins une électrode de commande (2) prévoit également la découpe de portions de colonne (CL).

4. Procédé selon la revendication 1, caractérisé en ce que les sixième et septième phases de dépôts de couches de semiconducteur (5) et d'isolant (6) se fait à travers un masque préservant la périphérie du substrat (1) de façon que les lignes métalliques (7) déposées au cours des phases ultérieures donnent lieu à des contacts situés directement sur le substrat (1).

5. Procédé selon la revendication 1, caractérisé en ce que le dépôt de silicium amorphe de la sixième phase est électriquement compensé afin de diminuer la photoconductivité.

6. Procédé selon la revendication 1, caractérisé en ce que le silicium amorphe déposé lors de la sixième phase est légèrement dopé de type p afin d'en diminuer la photoconductivité.

7. Transistor de commande réalisé selon le procédé de la revendication 1, comportant au moins une électrode de commande (2) en matériau conducteur oxydé déposée sur un substrat (1) et comportant également: au moins un élément de connexion (CX) comprenant une première couche de matériau métallique (31) déposée sur le substrat (1) et en contact avec l'électrode de commande (2) et une couche de semiconducteur amorphe dopé (41) superposée à la couche précédente; une colonne (CL) située à proximitée de l'élément de connexion (CX) et comprenant une couche continue de matériau métallique (32) déposée sur le substrat (1) et une couche de semiconducteur amorphe dopé (42) déposée sur la couche précédente; une ligne (LG) en contact avec la colonne (CL) et l'élément de connexion (CX) et comprenant une couche de matériau semiconducteur amorphe non dopé (5) chevauchant la ligne (LG) et l'élément de connexion (CX), une couche d'isolant (6) et une couche de matériau métallique (7) superposée à la couche précédente.

8. Transistor de commande selon la revendication 7, caractérisé en ce que l'élément de connexion (CX) comporte deux bras, l'un des bras étant en contact avec l'électrode de commande (E), l'autre bras étant reconnecté par la ligne (LG).

9. Transistor de commande selon la revendication 7, caractérisé en ce que l'élément de connexion (CX) a une forme générale d'un L.

10. Transistor de commande selon la revendication 7, caractérisé en ce que chaque colonne comporte une couche d'un matériau conducteur, de même nature que l'électrode de commande, comprise entre la couche de matériau métallique (32) de chaque colonne (CL) et cela sur toute la longueur de la colonne excepté à l'emplacement des points de croisement avec les lignes (LG).

11. Transistor de commande selon la revendication 7, caractérisé en ce que chaque ligne (LG) comporte un élargissement au niveau de chaque point de croisement avec une colonne (CL) et du contact avec l'élément de connexion (CX).

12. Transistor de commande selon la revendication 7, caractérisé en ce que chaque ligne (LG) ne comporte pas de matériau des couches de semiconducteur (5) et d'isolant (6) à la périphérie du substrat (1) de façon qu'à la périphérie le matériau métallique (7) des colonnes (LG) soit directement sur le substrat.

## Claims

1. A method for the manufacture of a control transistor for a flat viewing screen placed on a substrate (1), comprising the following succesive phases:

(a) a first phase of deposition, on a substrate (1), of an oxidized conductive material (2);

(b) a second phase of cutting at least one control electrode (2) in the layer of the conductive material;

(c) a third phase of deposition of a first layer of a metallic material (3);

(d) a fourth phase of deposition of amorphous material with n type doping (4);

(e) a fifth phase of cutting, in the n type doped amorphous semiconductor layers (4) and of metallic material (3) deposited previously, of at least one connection element (CX), of which one portion is in contact with the electrode (2) and of a continuous column (CL) situated in the vicinity of the connection element (CX) determining the dimension of the channel of the transistor;

(f) a sixth phase of deposition of a layer of a non-doped amorphous semiconductor material (5);

(g) a seventh phase of deposition of a layer of insulating material (6);

(h) an eighth phase of deposition of a second layer of metallic material (7);

(i) a ninth phase of cutting, in the layers of metallic material (7), of insulating material (6) and of amorphous non-doped semiconductor material (5), of at least one line (LG) spanning the column (CL) and the connection element (CX).

2. The method as claimed in claim 1, characterized in that the material (2) placed on the substrate (1) during the course of the first phase is a partially oxidized metallic oxide, in that the cutting in the second phase is performed by attack with the aid of a dilute acid and in that the second phase is completed by a phase of heating in the ambient air in order to completely oxidize the layer of metallic oxide.

3. The method as claimed in claim 1, characterized in that the second phase of cutting of at least one control electrode (2) also entails the cutting of portions of the column (CL).

4. The method as claimed in claim 1, characterized in that the sixth and the seventh phases of deposition of layers of semiconductor (5) and of insulator (6) are performed through a mask for the periphery of the substrate (1) in such a manner that the metallic lines (7) deposited in the course of the later phases give rise to contacts placed directly on the substrate (1).

5. The method as claimed in claim 1, characterized in that the deposition of amorphous silicon in the sixth phase is electrically compensated in order to reduce photoconductivity.

6. The method as claimed in claim 1, characterized in that the deposition of amorphous silicon in the sixth phase is of silicon with a slight p doping in order to diminish photoconductivity.

7. A control transistor produced by the method as claimed in claim 1, comprising at least one control electrode (2) of oxidized conductive material placed on a substrate (1) and also comprising: a least one connection element (CX) comprising a first layer of metallic material (31) placed on the substrate (1) and in contact with the control electrode (2) and a layer of doped amorphous semiconductor (41) placed on the preceding layer; a column (CL) situated in the vicinity of the connection element (CX) and comprising a continuous layer of metallic material (32) placed on the substrate (1) and a layer of a doped amorphous semiconductor (42) placed on the preceding layer; a line (LG) in contact with the column (CL) and the connection element (CX) and comprising a layer of non-doped amorphous semiconductor material (5) spanning the line (LG) and the connection element (CX), a layer of insulator (6) and a layer of metallic material (7) placed on the preceding layer.

8. The control transistor as claimed in claim 7, characterized in that the connection element (CX) comprises two arms, of which one is in contact with the control electrode (E) and of which the other is connected by the line (LG).

9. The control transistor as claimed in claim 7, characterized in that the connection element (CX) generally has the form of a letter L.

10. The control transistor as claimed in claim 7, characterized in that each column comprises a layer of a conductive material, of the same nature as the control electrode, comprised between the layer of metallic material (32) of each column (CL) for all the length of the column with the exception of the sites of intersections with the lines (LG).

11. The control transistor as claimed in claim 7, characterized in that each line (LG) comprises a widened part at the level of each point of intersection with a column (CL) and of contact with the connection element (CX).

12. The control transistor as claimed in claim 7, characterized in that each line (LG) is free of material of semiconductor layers (5) and insulation layers (6) at the periphery of the substrate (1) in such a manner that at the said periphery the metallic material (7) of the columns (LG) is directly on the substrate.

**Patentansprüche**

1. Verfahren zur Herstellung eines auf einem Substrat (1) angeordneten Schalttransistors für einen flachen Bildschirm, mit den folgenden aufeinanderfolgenden Phasen:

a) eine erste Phase des Niederschlags eines oxydierten leitenden Materials (2) auf dem Substrat (1);

b) eine zweite Phase des Ausstanzens wenigstens einer Steuerelektrode (2) in der Schicht aus leitendem Material;

c) eine dritte Phase des Niederschlags einer ersten Schicht aus metallischem Material (3);

d) eine vierte Phase des Niederschlags einer Schicht eines amorphen, n-dotierten Halbleiters (4);

e) eine fünfte Phase, bei der aus den vorher abgelagerten Schichten des amorphen, n-dotierten Halbleiters (4) und des metallischen Materials (3) wenigstens ein Verbindungselement (CX), von dem ein Bereich mit der Elektrode (2) in Kontakt steht, und eine in der Nähe des die Abmessungen des Kanals des Transistors festlegenden Verbindungselementes (CX) angeordnete ununterbrochene Säule (CL) ausgestanzt werden;

f) eine sechste Phase des Niederschlags einer Schicht aus amorphem, nichtdotierten Halbleitermaterial (5);

g) eine siebte Phase des Niederschlags einer Schicht aus isolierendem Material (6);

h) eine achte Phase des Niederschlags einer zweiten Schicht aus metallischem Material (7);

i) eine neunte Phase des Ausstanzens wenigstens einer mit der Säule (CL) und dem Verbindungselement (CX) sich überschneidenden Leitung (LG) in den Schichten aus metallischem Material (7), aus isolierendem Material (6) und aus dem amorphen, nichtdotierten Halbleitermaterial (5).

2. Verfahren gemäß Anspruch 1, dadurch gekennzeichnet, daß das im Verlauf der ersten Phase auf dem Substrat (1) abgelagerte Material (2) ein teilweise oxydiertes Metalloxyd ist, daß das Ausstanzen der zweiten Phase durch Angreifen mit Hilfe einer Dünnsäure geschieht und daß die zweite Phase durch eine Phase des Glühens bei Umgebungsluft abgeschlossen wird, um die Schicht des Metalloxyds vollständig zu oxydieren.

3. Verfahren gemäß Anspruch 1, dadurch gekennzeichnet, daß die zweite Phase des Ausstanzens wenigstens einer Steuerelektrode (2) gleichermaßen das Ausstanzen von Abschnitten der Säule (CL) vorsieht.

4. Verfahren gemäß Anspruch 1, dadurch gekennzeichnet, daß die sechste und die siebte Phase des Niederschlags der Halbleiterschicht (5) und der Isolierschicht (6) durch eine den Rand des Substrats (1) erhaltende Maske hindurch geschieht, derart, daß die im Verlauf der späteren Phasen abgelagerten Metalleitungen (7) den direkt auf dem Substrat (1) angeordneten Kontakten Platz geben.

5. Verfahren gemäß Anspruch 1, dadurch gekennzeichnet, daß der Niederschlag von amorphem Silizium in der sechsten Phase elektrisch kompensiert wird, um die Fotoleitfähigkeit zu verringern.

6. Verfahren gemäß Anspruch 1, dadurch gekennzeichnet, daß das während der sechsten Phase abgelagerte amorphe Silizium leicht p-dotiert ist, um die Fotoleitfähigkeit zu verringern.

7. Schalttransistor, der mit dem Verfahren gemäß Anspruch 1 hergestellt ist, mit wenigstens einer Steuerelektrode (2) aus auf einem Substrat (1) abgelagertem, leitendem oxydierten Material, mit wenigstens einem Verbindungselement (CX), das eine auf dem Substrat (1) abgelagerte und mit der Steuerelektrode (2) in Kontakt befindliche Schicht aus metallischem Material und eine Schicht eines amorphen, dotierten Halbleiters (41), die über der vorangehenden Schicht gelagert ist, umfaßt, mit einer Säule (CL), die in der Nähe des Verbindungselementes (CX) angeordnet ist und eine auf dem Substrat (1) abgelagerte ununterbrochene Schicht aus metallischem Material (32) und eine auf der vorangehenden Schicht abgelagerte Schicht eines amorphen, dotierten Halbleiters (42) umfaßt, mit einer Leitung (LG), die sich mit der Säule (CL) und mit dem Verbindungselement (CX) in Kontakt befindet und eine mit der Säule (CL) und dem Verbindungselement (CX) überlappende Schicht aus amorphem, nichtdotiertem Halbleitermaterial (5), eine Isolierschicht (6) und eine über der vorangehenden Schicht gelagerte Schicht aus metallischem Material (7) umfaßt.

8. Schalttransistor gemäß Anspruch 7, dadurch gekennzeichnet, daß das Verbindungselement (CX) zwei Zweige umfaßt, wobei sich einer der Zweige mit der Steuerelektrode (E) in Kontakt befindet und der andere Zweig mit der Leitung (LG) verbunden ist.

9. Schalttransistor gemäß Anspruch 7, dadurch gekennzeichnet, daß das Verbindungselement (CX) die allgemeine Form eines L besitzt.

10. Schalttransistor gemäß Anspruch 7, dadurch gekennzeichnet, daß jede Säule eine Schicht aus leitendem Material von der gleichen Art wie die Steuerelektrode umfaßt, die zwischen der Schicht aus dem metallischen Material (32) einer jeden Säule (CL) eingeschlossen ist und dies über die gesamte Länge der Säule mit Ausnahme der Orte der Kreuzungspunkte mit den Leitungen (LG).

11. Schalttransistor gemäß Anspruch 7, dadurch gekennzeichnet, daß jede Leitung (LG) auf dem Niveau eines jeden Kreuzungspunktes mit einer Säule (CL) und des Kontakts mit dem Verbindungselement (CX) eine Verbreiterung aufweist.

12. Schalttransistor gemäß Anspruch 7, dadurch gekennzeichnet, daß keine Leitung (LG) am Rand des Substrats (1) Material der Halbleiterschicht (5) und der Isolierschicht (6) aufweist, derart, daß sich der Rand des metallischen Materials (7) der Säulen (LG) direkt auf dem Substrat befindet.

# FIG_1

# FIG_2

# FIG_3

# FIG_4

# FIG_5

# FIG_6

5  6

ISOLANT

Si(i)

Si+   METAL   Si+  41  31   2   1

42  32

# FIG_7

7

METAL

ISOLANT  6

Si+   METAL   Si+   2   Si(i)   5

42  32   41  31   1

# FIG_8

# FIG_9

# FIG_10

# FIG_11

FIG_12

FIG_13

EP 0 216 673 B1